# EUROPEAN PATENT SPECIFICATION

(11) **EP 1 720 207 B1**
(45) Date of publication and mention of the grant of the patent: **03.08.2011**
(21) Application number: 05022929.3
(22) Date of filing: 20.10.2005
(51) Int. Cl.: H01L 51/52

(54) **Apparatus for directional organic light emitting diodes**
Vorrichtung für organische elektrolumineszente Dioden mit gerichteter Lichtemission
Dispositif pour des diodes organiques électroluminescentes à émission lumineuse directionnelle

(30) Priority: 08.04.2005 US 102076
(43) Date of publication of application: 08.11.2006
(73) Proprietor: Avago Technologies ECBU IP (Singapore) Pte. Ltd., Singapore 768923 (SG)
(72) Inventor: Sigalas, Mihail M., Loveland CO 80537-0599 (US)
(74) Representative: Dilg, Haeusler, Schindelmann Patentanwaltsgesellschaft mbH

(56) References cited:
- WO-A-2004/013921
- US-A1- 2005 156 512
- US-B1- 6 396 208
- GIFFORD DAWN K ET AL: "Emission through one of two metal electrodes of an organic light-emitting diode via surface-plasmon cross coupling" APPLIED PHYSICS LETTERS, AIP, AMERICAN INSTITUTE OF PHYSICS, MELVILLE, NY, US, vol. 81, no. 23, 2 December 2002 (2002-12-02), pages 4315-4317, XP012032674 ISSN: 0003-6951
- EBBESEN T W ET AL: "Extraordinary optical transmission through sub-wavelength hole arrays" NATURE, NATURE PUBLISHING GROUP, LONDON, GB, vol. 391, no. 6668, 12 February 1998 (1998-02-12), pages 667-669, XP002133009 ISSN: 0028-0836

## Description

### Background

Improving the extraction efficiency of light emitting diodes (LEDs) increases the overall efficiency of LEDs. Increasing LED directionality makes LEDs more attractive for certain applications such as projectors. Several different configurations have been examined for GaAs and GaN LEDs by J.K. Hwang et al. in Phys. Rev. B 60, pp.4688, 1999, Y. Xu et al. in J. Opt. Soc. Am. B 16,465 (1999) and R.K. Lee et al. J. Opt. Soc. Am. B17 1438, (1999).

Improved extraction efficiency in the area of organic light emitting diodes (OLEDs) is discussed by P. A. Hobson et al. in Advanced Materials, 14, 19, 2002.

US 6 396 208 discloses an organic electroluminescent device in which the electrode in the light-emitting side has small protrusions.

Document "Emission through one of two metal electrodes of an organic light-emitting diode via surface-plasmon cross coupling" from Gifford et al. discloses experimental and theoretical analyses which indicate that cross coupling between surface plasmons on opposite sides of the metal cathode layer enables the transmission of electroluminescence through the practically opaque metal.

Document "Extraordinary optical transmission through sub-wavelength hole arrays" from Ebbesen et al. discloses that a fundamental constraint in manipulating light is the extremely low transmittivity of apertures smaller than the wavelength of the incident photon.

### Brief Summary of the Invention

In accordance with the invention, total radiated power, extraction efficiency and directionality of organic light emitting diodes (OLEDs) may be improved by providing an OLED as recited in claim 1 which uses two metal electrodes to sandwich the organic layers, one metal electrode serving as the anode and the other metal electrode serving as the cathode. Light is outcoupled through one of the two metal electrodes that has been suitably perforated to provide high directionality.

### Brief Description of the Drawings

FIG. 1 shows an embodiment in accordance with the invention.
FIG. 2 shows an electrode patterned in accordance with the invention.
FIG. 3 shows total radiated power versus a/λ for an embodiment in accordance with the invention.
FIG. 4 shows the extraction ratio versus a/λ for an embodiment in accordance with the invention.
FIG 5a. shows a radiation pattern of a single horizontal dipole in accordance with the invention.
FIG. 5b shows a prior art radiation pattern of a single horizontal dipole where light is not outcoupled through a high conductivity metal electrode.
FIG. 6 shows total radiated power versus a/λ for embodiments in accordance with the invention.
FG. 7 shows total radiated power versus a/λ for embodiments in accordance with the invention.
FIG. 8 shows the extraction ratio versus a/λ for embodiments in accordance with the invention.
FIG. 9 shows total radiated power versus a/λ for embodiments in accordance with the invention.
FIG. 10 shows the extraction ratio versus a/λ for embodiments in accordance with the invention.

### Detailed Description

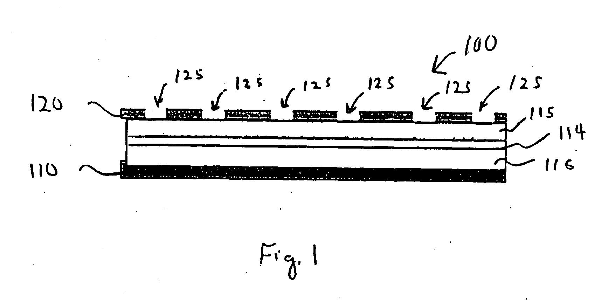

FIG. 1 shows an organic light emitting diode (OLED) in accordance with the invention in a cross-sectional view. Metal electrodes 110 and 120 are made of a metal having a high conductivity. Note, that either metal electrode 110 or 120 may be the cathode electrode with the remaining metal electrode being the anode electrode. The metal electrode that functions as the cathode typically has a low work function to provide a low energy barrier for electron injection while the metal electrode that functions as the anode typically has a high work function to provide a low energy barrier for hole injection.

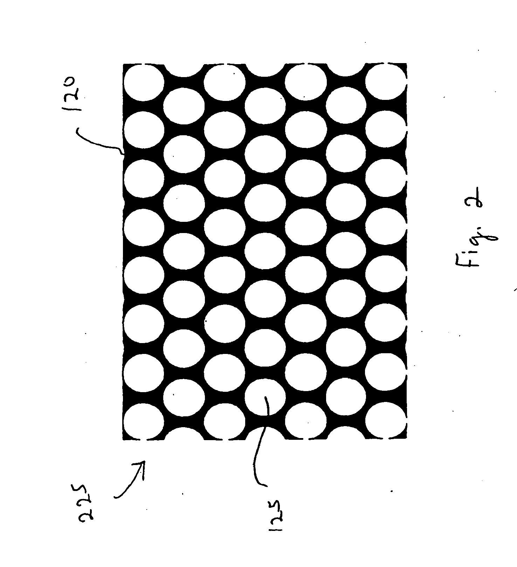

Metal electrodes 110 and 120 sandwich organic layers 115, 116 and 114. Organic layers 115, 116 and 114 may typically have an average refractive index of about 1.75 and may be small molecule or polymeric based. If metal electrode 120 is the anode electrode, layer 115 is typically a thin hole transporting layer (HTL), made, for example, from diamines, while layer 116 is typically an organic electron transporting layer (ETL) next to metal electrode 110 which is the cathode electrode. If metal electrode 120 is the cathode electrode, layer 115 is typically an organic electron transporting layer (ETL) while layer 116 is typically a thin hole transporting layer (HTL), made, for example, from diamines. Layer 114 is the emissive layer. In accordance with the invention, metal electrode 120 is a patterned surface with holes 125 forming a lattice such as triangular lattice 225 shown in top view in FIG. 2. The surface may also be patterned with holes 125 forming a honeycomb or quasiperiodic lattice, for example. Note that holes 125 may be filled with air, SiO₂, SiNₓ or other suitable optically transparent dielectric material. Numerous methods known to those skilled in the art may be used to form holes 125. In accordance with the invention, holes may be, for example, circular, elliptical, circular, elliptical, triangular or hexagonal in cross-section. Other polygonal cross-sections may also be used in accordance with the invention.

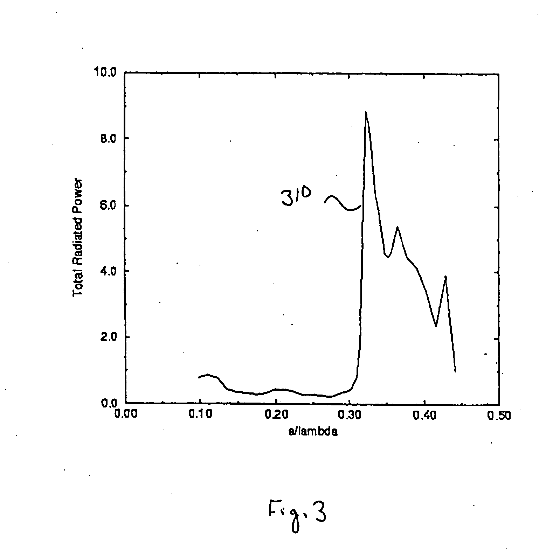

FIG. 3 shows the total radiated power (TRP) for an embodiment in accordance with the invention where the TRP is the ratio of the TRP of the embodiment in accordance with the invention divided by the TRP of dipoles in an infinitely long uniform organic material having no metal electrodes. The TRP is calculated using a finite difference time domain (FDTD) method typically used to model OLEDs, see, for example, J.K. Hwang et al in Physical Review B, 60, 4688, 1999 or H.Y. Ryu et al. in Journal of the Optical Society of Korea, 6, 59, 2002. For the purpose of the calculation, emissive layer 114 is approximated as a plane having 2000 planar dipoles with random orientation in the plane. The planar dipoles are excited at different phases to reduce any location and orientation resonances. Metal electrodes 110 and 120 are assumed to be perfect conductors with no losses for the purposes of calculation. In this embodiment, the lattice constant is taken to be *a*, the total thickness, *t*, of organic layers 115,114 and 116 is taken to be about 0.8125*a*, the radius of holes 125 is taken to be about 0.36*a*, and the plane of dipoles is separated from electrode 110 by a distance, *t_{d}*, of about 0.5*a*.

Curve 310 in FIG. 3 shows an enhancement of the TRP by almost a factor of eight at an *a*/λ of 0.326 where λ is the free space wavelength. The internal quantum efficiency of the OLED is improved. When the plane of dipoles is located halfway between electrodes 110 and 120, a maximum of TRP is achieved because metal electrodes 110 and 120 function as mirrors. Electrode 110 functions as an essentially perfect mirror while electrode 120 functions as an imperfect mirror because of the presence of holes 125. The electric field maximum typically lies at or close to the midpoint between metal electrodes 110 and 120.

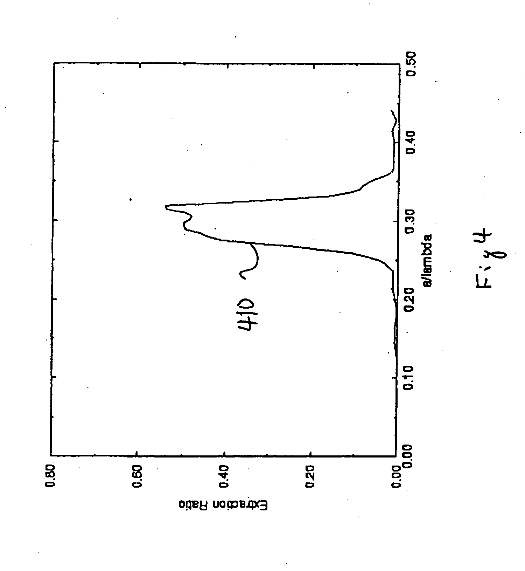

Curve 410 in FIG. 4 shows the ratio of the power radiated into a cone with a half angle of 30 degrees to the total radiated power for an embodiment in accordance with the invention. The maximum for the ratio occurs at an *a*/λ of about 0.313 at 53 percent and falls rapidly for higher ratios of *a*/λ. The value of *a*/λ is not unexpected as the lowest order mode that can exist between the two metal electrodes 110 and 120 in organic layers 114, 115 and 116 having a total thickness *t,* is the *λₙ*/2 wavelength mode as the boundary conditions require the wavefunction to be zero on metal electrodes 110 and 120. λ*ₙ* is the optical wavelength in the organic layers. Hence, λₙ / 2 = λ/2*n* = *t* where *n* is the average refractive index of organic layers 114, 115 and 116. Writing *t* = α*a* , where *a* is the lattice constant, then gives *a*/λ = 1/2*n*α = 0.35 which is on the order of the results from FIGs. 3 and 4.

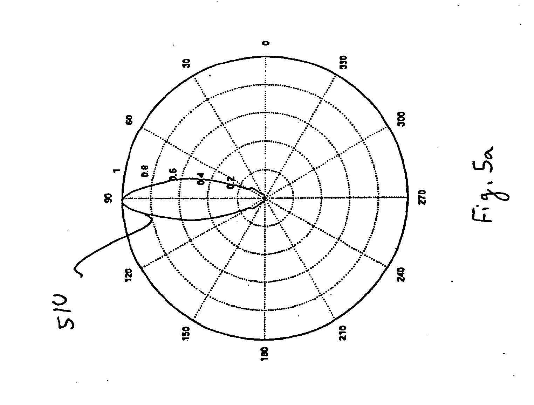

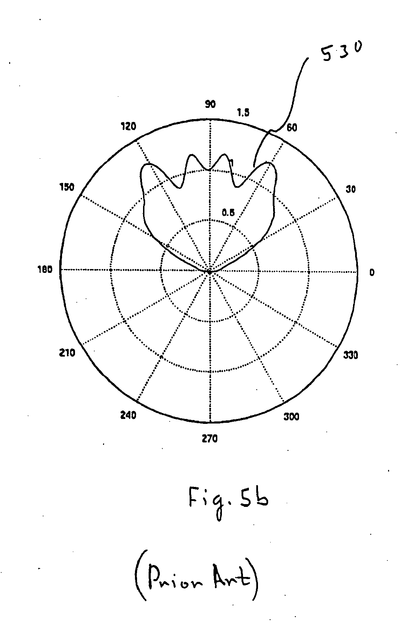

FIG. 5a shows radiation pattern 510 of a single horizontal dipole excited at an a /λ of about 0.313 for an embodiment in accordance with the invention. Radiation pattern 510 is highly directional with the power being radiated dropping by half within plus or minus about 17 degrees from the forward 90 degree direction. For the purposes of this patent application, the term "highly directional" refers to embodiments in accordance with the invention where at least 40 percent of the power is radiated into a cone with a half angle of about 30 degrees. FIG. 5b shows radiation pattern 530 of a single horizontal dipole excited at an *a*/λ of about 0.313 where light is not outcoupled through a high conductivity metal electrode. Light is radiated into a cone with a half angle of about 60 degrees.

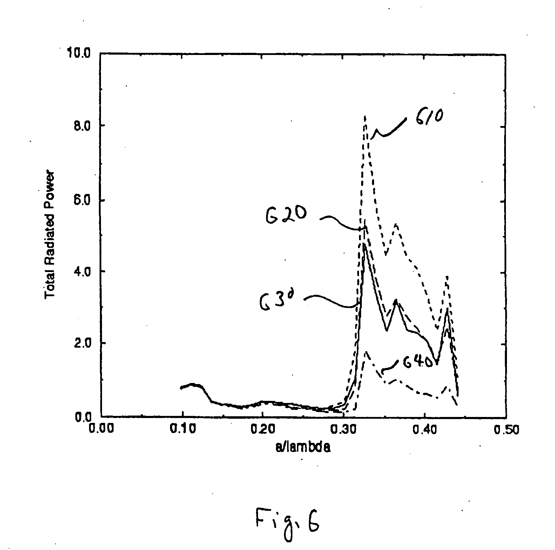

FIG. 6 shows total radiated power as a function of *a*/λ for the plane of dipoles separated from metal electrode 110 by various values of *t_{d}*/*a* for a combined thickness of layers 115, 114 and 116. The radius of holes 125 in metal electrode 120 is r~ 0.36*a* where *a* is the lattice constant. Curves 610, 620, 630 and 640 for total radiated power correspond to a *t_{d}*/*a* of 0.5, 0.25, 0.688 and 0.125, respectively. The maximum TRP is at *a*/λ of about 0.313 for curves 610, 620, 630 and 640. The difference in TRP for values of *t_{d}la* of 0.375, 0.438 and 0.5 is less than about 5 percent with the TRP being about 8.3 for these three values. Hence, emissive layer 114 is typically placed halfway between metal electrodes 110 and 120 as noted above.

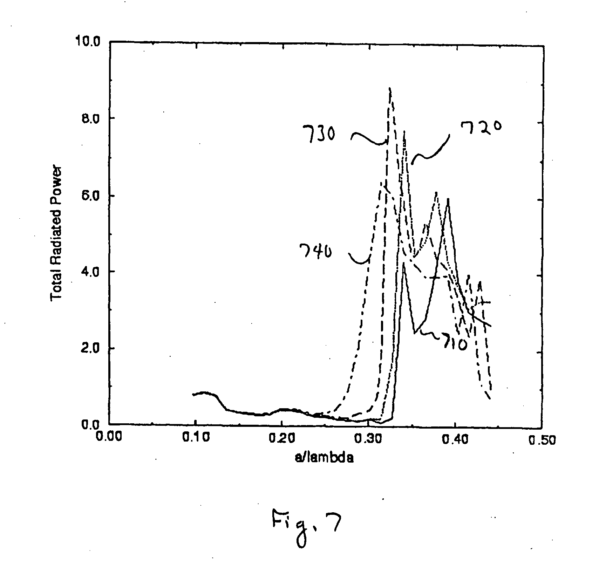

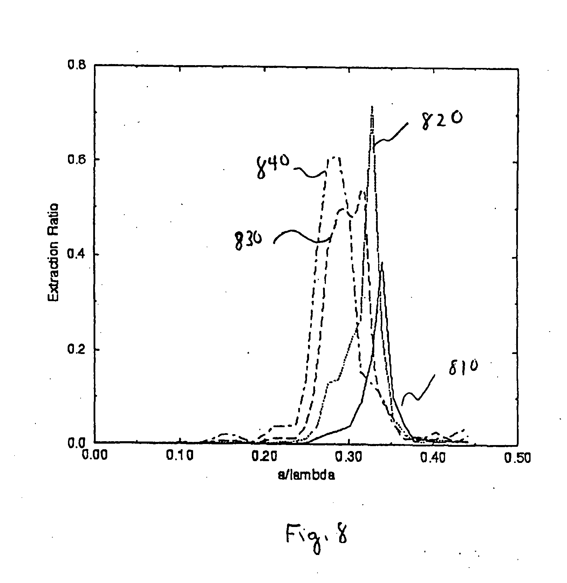

FIG. 7 shows the TRP as a function of *a*/λ for a triangular lattice of holes 125 filled with air in metal electrode 120 with other parameter as for FIG. 3. The radius of holes 125 is 0.24a, 0.3a, 0.36a and 0.42a for curves 710, 720, 730 and 740, respectively. The peak of the TRP is seen to move to lower values of *a*/λ as the radius of holes 125 increases. FIG. 8 shows the extraction ratio into a cone with a half angle of 30 degrees for the configurations of FIG. 7. Curves 810, 820, 830 and 840 correspond to a radius of holes 125 of 0.24a, 0.3a, 0.36a and 0.42a, respectively.

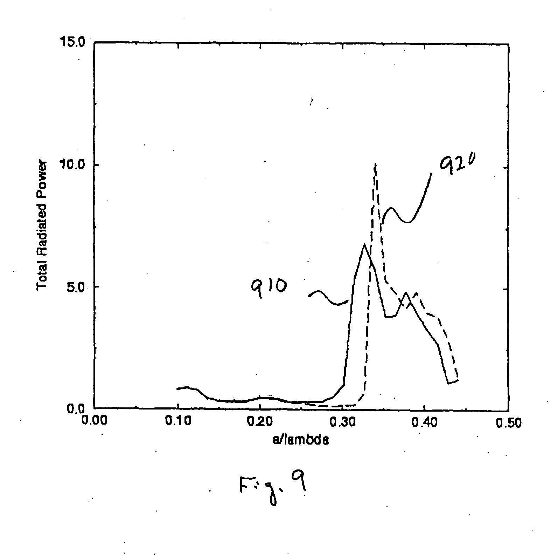

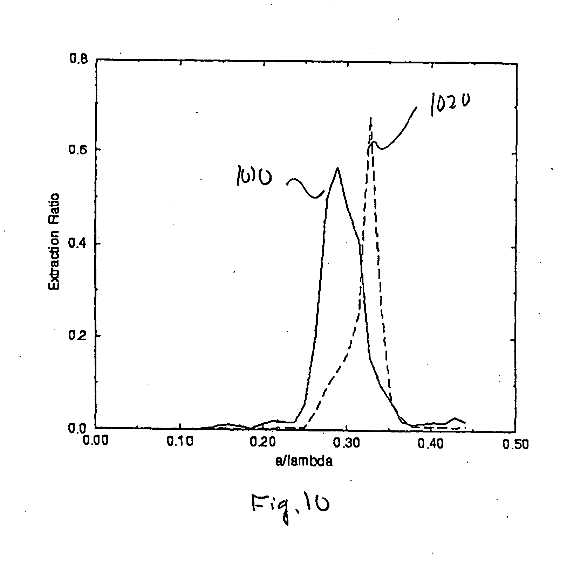

FIG. 9 shows the TRP for a square lattice of holes 125 filled with air in metal electrode 120. For curve 910, holes 125 are circles with a radius of *r* about 0.4a and for curve 920, holes 125 are square holes 125 with sides of about 0.5a. FIG. 10 shows the extraction ratio into a cone with a half angle of 30 degrees for the square lattice configurations of FIG. 9. Curve 1010 corresponds to circular holes 125 with a radius of r about 0.4a while curve 1020 corresponds to square holes with sides of about 0.5a. The extraction ratio for the square lattice with circular holes 125 as shown by curve 1010 is comparable to the extraction ratios for triangular lattices with circular holes 125 having *r*/*a~* 0.36 and 0.42 for curves 830 and 840, respectively. The peaks for curves 830, 840 and 1010 are relatively wide, enhancing manufacturability which is typically an important consideration. The extraction ratio for the square lattice with square holes 125 as shown by curve 1020 is comparable to the extraction ratio for a triangular lattice with circular holes having *r*/*a*~ 0.3 as shown by curve 820 in FIG. 8. Both curves 1020 and 820 show a relatively narrow peak which typically makes manufacturing more difficult because of the tighter manufacturing tolerances required. The TRP in FIG. 9 for curve 920 where square holes 125 are used is about 10 which is an improvement of about 15 percent or better over the TRP shown in FIG. 7 for the configurations represented by curves 710, 720, 730 and 740.

## Claims

1. An organic light emitting diode (100) comprising:
a plurality of organic layers (114, 115, 116); and
a first (110) and second (120) highly conducting metal electrode sandwiching said plurality of organic layers (114, 115, 116), said second highly conducting electrode (120) comprising a suitably patterned surface comprising a lattice of holes (125) penetrating through said second highly conducting electrode (120) such that said organic light emitting diode (100) is operable to emit light in a highly directional radiation pattern, wherein highly directional radiation pattern means that at least 40 percent of the power is radiated into a cone with a half angle of about 30 degrees,
wherein the radius of the holes is 0.36a, where a is the lattice constant.

2. The apparatus of Claim 1 wherein said lattice of holes (125) is a triangular lattice of holes (225).

3. The apparatus of Claim 1 wherein said lattice of holes (125) is a square lattice of holes.

4. The apparatus of Claim 1 wherein holes of said lattice of holes (125) have a square cross-section.

5. The apparatus of Claim 1 wherein holes of said lattice of holes (125) have a circular cross-section.

6. The apparatus of Claim 1 wherein holes (125) of said lattice of holes (125) are filled with a material chosen from SiO₂, SiNₓ and air.

7. The apparatus of Claim 1 wherein said second highly conducting electrode (120) is a cathode electrode.

8. The apparatus of Claim 1 wherein one (e.g. 114) of said plurality of organic layers (114,115,116) is an emissive layer.

9. The apparatus of Claim 1 wherein one of said plurality of organic layers (114,115, 116) is comprised of diamines.

10. The apparatus of Claim 1 wherein said plurality of organic layers (114,115,116) are polymeric based.

## Patentansprüche

1. Eine organische lichtemittierende Diode (100) aufweisend:
eine Mehrzahl von organischen Schichten (114, 115, 116); und
eine erste (110) und zweite (120) stark leitende Metallelektrode, welche die Mehrzahl der organischen Schichten (114, 115, 116) dazwischen einschließen, wobei die zweite stark leitende Elektrode (120) eine geeignet strukturierte Oberfläche aufweist, die ein Gitter von Löchern (125) aufweist, die durch die zweite stark leitende Elektrode (120) so durchdringen, dass die organische lichtemittierende Diode (100) betreibbar ist Licht in einem stark gerichteten Strahlungsmuster zu emittieren, wobei stark gerichtetes Strahlungsmuster bedeutet, dass zumindest 40 % der Leistung in einem Kegel mit einem Halbwinkel von ungefähr 30° abgestrahlt wird, wobei der Radius der Löcher 0,36 a ist, wobei a die Gitterkonstante ist.

2. Vorrichtung gemäß Anspruch 1, wobei das Gitter von Löchern (125) ein dreieckiges Gitter von Löchern (225) ist.

3. Vorrichtung gemäß Anspruch 1, wobei das Gitter von Löchern (125) ein quadratisches Gitter von Löchern ist.

4. Vorrichtung gemäß Anspruch 1, wobei Löcher des Gitters von Löchern (125) einen quadratischen Querschnitt haben.

5. Vorrichtung gemäß Anspruch 1, wobei Löcher des Gitters von Löchern (125) einen runden Querschnitt haben.

6. Vorrichtung gemäß Anspruch 1, wobei Löcher (125) des Gitters von Löchern (125) mit einem Material gefüllt sind, das aus SiO₂, SiNₓ und Luft gewählt wird.

7. Vorrichtung gemäß Anspruch 1, wobei die zweite stark leitende Elektrode (120) eine Kathodenelektrode ist.

8. Vorrichtung gemäß Anspruch 1, wobei eine (z. B. 114) der Mehrzahl von organischen Schichten (114, 115, 116) eine Emissionsschicht ist.

9. Vorrichtung gemäß Anspruch 1, wobei eine der Mehrzahl von organischen Schichten (114, 115, 116) Diamine aufweist.

10. Vorrichtung gemäß Anspruch 1, wobei die Mehrzahl der organischen Schichten (114, 115, 116) polymerbasiert sind.

## Revendications

1. Diode électroluminescente organique (100), comprenant :
une pluralité de couches organiques (114, 115, 116) ; et
des première (110) et deuxième (120) électrodes métalliques hautement conductrices prenant en sandwich ladite pluralité de couches organiques (114, 115, 116), ladite deuxième électrode hautement conductrice (120) comprenant une surface adéquatement modelée, comprenant un réseau cristallin de trous (125) pénétrant à travers ladite deuxième électrode hautement conductrice (120) de sorte que ladite diode électroluminescente organique (100) peut fonctionner pour émettre de la lumière selon un motif de rayonnement hautement directionnel, dans lequel motif de rayonnement hautement directionnel signifie qu'au moins 40 pour cent de la puissance sont rayonnés dans un cône avec un demi-angle d'environ 30 degrés,
dans lequel le rayon des trous est de 0,36 a, où a est la constante de réseau cristallin.

2. Appareil selon la revendication 1, dans lequel ledit réseau cristallin de trous (125) est un réseau cristallin triangulaire de trous (225).

3. Appareil selon la revendication 1, dans lequel ledit réseau cristallin de trous (125) est un réseau cristallin carré de trous.

4. Appareil selon la revendication 1, dans lequel les trous dudit réseau cristallin de trous (125) ont une section carrée.

5. Appareil selon la revendication 1, dans lequel les trous du réseau cristallin de trous (125) ont une section circulaire.

6. Appareil selon la revendication 1, dans lequel les trous (125) dudit réseau de trous (125) sont remplis avec un matériau choisi parmi SiO₂, SiNₓ et l'air.

7. Appareil selon la revendication 1, dans lequel ladite deuxième électrode hautement conductrice (120) est une électrode cathode.

8. Appareil selon la revendication 1, dans lequel une couche (par exemple 114) de ladite pluralité de couches organiques (114, 115, 116) est une couche émissive.

9. Appareil selon la revendication 1, dans lequel une couche de ladite pluralité de couches organiques (114, 115, 116) est composée de diamines.

10. Appareil selon la revendication 1, dans lequel ladite pluralité de couches organiques (114, 115, 116) est à base de polymère.
